# EUROPEAN PATENT SPECIFICATION

(11) **EP 4 152 376 B1**
(45) Date of publication and mention of the grant of the patent: **10.09.2025**
(21) Application number: 21817520.6
(22) Date of filing: 20.05.2021
(51) Int. Cl.: H01L 23/367, H01L 23/31, H01L 25/07

(54) **CHIP PACKAGE STRUCTURE AND ELECTRONIC DEVICE WITH THE SAME**
CHIP-PACKUNGSSTRUKTUR UND ELEKTRONISCHES GERÄT MIT DIESER
STRUCTURE DE BOÎTIER DE PUCE ET DISPOSITIF ÉLECTRONIQUE AVEC CELLE-CI

(30) Priority: 30.05.2020 CN 202020965658 U
(43) Date of publication of application: 22.03.2023
(73) Proprietor: Huawei Technologies Co., Ltd., Longgang District, Shenzhen, Guangdong 518129 (CN)
(72) Inventor: HOU, Zhaozheng, Shenzhen, Guangdong 518129 (CN); PENG, Hao, Shenzhen, Guangdong 518129 (CN)
(74) Representative: Gill Jennings & Every LLP
(86) International application number: PCT/CN2021/094996
(87) International publication number: WO 2021/244304

(56) References cited:
- CN-A- 102 956 584
- CN-A- 103 117 275
- CN-A- 109 830 465
- CN-A- 111 029 332
- CN-U- 212 517 170
- US-A1- 2015 008 566
- US-A1- 2015 035 135
- US-A1- 2017 317 000
- US-A1- 2018 019 175
- US-A1- 2020 091 031
- US-A1- 2020 091 076

## Description

### TECHNICAL FIELD

This invention relates to the field of electrical components, and in particular, to a chip package structure and an electronic device.

### BACKGROUND

Chip package is packaging a chip in a package structure and leading out an electrode of the chip to a housing, so that a packaged chip package structure can be electrically connected to another structure. By packaging the chip in the housing, the chip can be isolated from the outside, so as to prevent a problem that electrical performance is degraded due to corrosion of a chip circuit by external impurities or other impact. In addition, the packaged chip package structure may have higher strength than a separate chip, so that it is more convenient for installation and transportation, and also facilitates subsequent processes such as connection between the chip and another structure.

In a general packaging technology, an electrode in a chip usually leads out a pin to a housing in a solder ball soldering manner. When the packaged package structure is installed on a circuit board, a solder ball connected to the electrode of the chip is soldered to a solder pad of the circuit board, to implement an electrical connection between the chip and the circuit board. However, a position of the electrode in the chip is fixed, and therefore a position of the solder ball is also relatively fixed. In general, positions of solder pads on circuit boards of different specifications are pre-designed. When the packaged chip needs to be connected to the circuit board in a solder ball soldering manner, a position of an electrode in the chip needs to be corresponding to a position of the solder pad on the circuit board. Therefore, the packaged chip can only be connected to a circuit board whose solder pad is corresponding to the electrode of the chip, thereby limiting a usable type of the circuit board. US 2017/317000 A1 discloses an electronic component comprising a substrate, a chip, and a sealing resin. US 2020/091076 A1 discloses packaged electronic devices and integrated circuits with a ceramic or other thermally conductive, electrically insulating substrate.

### SUMMARY

This invention provides a chip package structure that can be applied to various types of circuit boards, and an electronic device that includes the chip package structure.

According to a first aspect, this invention provides a chip package structure, where the chip package structure includes an insulation layer, a packaging layer, and a heat sink that are sequentially laminated. The packaging layer includes a packaging substrate, a chip, and an electrode cable, where the chip is embedded in the packaging substrate, the chip includes a first side and a second side that are disposed opposite to each other, the chip includes a first electrode disposed on the first side, and the electrode cable is formed on a surface of the packaging substrate and is electrically connected to the first electrode. The insulation layer covers the electrode cable, an opening is disposed on the insulation layer, and the opening is disposed corresponding to the electrode cable to expose a part of the electrode cable. The heat sink is integrated with the packaging layer. The second side of the chip is covered with a metal layer, and the metal layer is electrically connected to the electrode cable. The chip comprises a second electrode disposed on the second side, and the metal layer is the second electrode.

In accordance with the invention, the first electrode of the chip in the chip package structure is led out by using the electrode cable, and an opening is disposed on the insulation layer that covers the electrode cable, to implement an electrical connection between the chip package structure and another structure of an electronic device by using the electrode cable that exposes the opening. In this way, an extension position of the electrode cable and a position of the opening on the insulation layer can be adjusted based on a type of a circuit board on which the chip package structure is installed, so that the chip package structure can be flexibly applied to various types of circuit boards. In addition, the heat sink and the packaging layer in the chip package structure in this invention are integrated. Compared with a common manner of fixing the heat sink to the packaging layer through soldering, gluing, or using a fastener, a defect such as a hole does not easily occur at a position at which the heat sink and the packaging layer are combined, so that heat of the packaging layer can be efficiently transmitted to the heat sink, and a connection between the heat sink and the packaging layer is more secure. In addition, because no soldering, gluing, or fastener is required, a manufacturing process can be reduced.

The second side of the chip is covered with a metal layer, and the metal layer is electrically connected to the electrode cable.

In accordance with the invention, heat generated on the first side of the chip can be transmitted to the heat sink sequentially through the first electrode, the electrode cable, and the metal layer, and then be dissipated by using the heat sink, to avoid a problem that heat generated on the first side of the chip cannot be rapidly dissipated, thereby affecting performance of the chip. In addition, the first side of the chip is connected to the second side of the chip by using the first electrode, the electrode cable, and the metal layer, so that heat generated on the two sides of the chip can be transmitted to each other, heat at each position of the chip can be relatively evenly distributed, and heat aggregation at a specific position of the chip can be avoided to affect performance of the chip. In addition, the metal layer is laminated on the second side of the chip, and therefore, the heat sink can be formed on a side of the second side of the chip in an electroplating manner more easily, and a better electroplating effect is implemented, so that a combination of the heat sink and the chip is more stable, and heat of the chip can be transmitted to the heat sink more efficiently.

The chip includes a second electrode disposed on the second side, and the metal layer is the second electrode. That is, the metal layer transmits heat, and can be further used to transmit a signal. Specifically, when the chip includes a transistor configured to process a plurality of functions, a quantity of electrodes in the chip is large, and some second electrodes may be disposed on the second side of the chip to ensure a signal transmission effect. Alternatively, when the chip is a high-power chip, the second electrode is disposed on the second side, so that heat generated when the chip works can be dissipated from the first side and the second side of the chip faster, thereby realizing a better heat dissipation effect.

In some implementations, the packaging substrate includes an accommodating cavity, and the chip is accommodated in the accommodating cavity. There is a gap between the chip and the accommodating cavity, and the gap is filled with a thermally conductive insulation material. A gap between the chip and an inner wall of the accommodating cavity is filled with a thermally conductive insulation material, so that the chip can be stably fixed in the accommodating cavity, and heat generated when the chip works can be transmitted by using the thermally conductive insulation material, thereby improving heat dissipation efficiency in the chip.

In some implementations, the heat sink is laminated on the packaging substrate and is integrated with the packaging substrate, and the heat sink is in contact with the second side of the chip, so that heat generated when the chip works can be rapidly transmitted to the heat sink, thereby improving heat dissipation efficiency.

In some implementations, the chip package structure further includes a thermally conductive insulation layer, and the thermally conductive insulation layer covers the packaging layer. The heat sink is located on a side that is of the thermally conductive insulation layer and that is away from the packaging layer, and the heat sink is integrated with the thermally conductive insulation layer. The thermally conductive insulation layer is in contact with the second side of the chip. When the chip is a high-power chip, that is, when a voltage transmitted to the chip is relatively high, the chip is separated from the heat sink by using the thermally conductive insulation layer to avoid a safety risk caused by a leakage of power from the chip.

In some implementations, the chip package structure further includes a soldering washer, where the soldering washer includes a first part and a second part that are connected. The first part covers an area in which the electrode cable exposes the opening, and the second part covers a peripheral edge of the opening of the insulation layer.

In this implementation, a relatively large soldering washer is formed at a position of the opening of the insulation layer, and the first part of the soldering washer is connected to the area in which the electrode cable exposes the opening, so that a size of a connection pin when the chip package structure is electrically connected to another structure can be increased, and the chip package structure can be more easily and stably electrically connected to another structure. In addition, a part of the soldering washer covers the insulation layer. Therefore, compared with a manner of fixing a solder ball or a soldering tin to the electrode cable through the opening of the insulation layer, the solder ball or the soldering tin can implement an electrical connection between the chip package structure and the circuit board without needing to be connected to the electrode cable through the opening. That is, the chip package structure can be more easily electrically connected to another structure by using the soldering washer, and a connection yield is higher.

In some implementations, the heat sink includes a metal sheet, and the metal sheet is formed in the packaging layer through electroplating. The metal sheet is made of a metal material, and the metal material has good electrical conductivity, thereby implementing a good heat dissipation effect.

In some implementations, the heat sink further includes a plurality of heat dissipation fins, where the heat dissipation fins are formed on a side that is of the metal sheet and that is away from the packaging layer, and there are gaps among the heat dissipation fins. The heat dissipation fins are disposed on the side that is of the metal sheet and that is away from the packaging layer, to increase a heat dissipation area in which the heat sink performs heat exchange with the outside, thereby improving heat dissipation efficiency of the heat sink.

According to a second aspect, this invention further provides an electronic device, where the electronic device includes a circuit board and the chip package structure described in any one of the above, and a part of the electrode cable that exposes the opening in the chip package structure is electrically connected to the circuit board. In this implementation, the chip package structure can be flexibly applied to various types of circuit boards, thereby reducing a production requirement and production costs. In addition, the chip package structure of this invention has a good heat dissipation capability, so that service life of the chip package structure can be prolonged, and quality of the electronic device can be improved.

### BRIEF DESCRIPTION OF DRAWINGS

FIG. 1 is a cross sectional schematic view of an electronic device according to some implementations of this invention;
FIG. 2 is a schematic diagram of a structure of a chip package structure according to an implementation not covered by the present invention but useful for its understanding;
FIG. 3 is a schematic diagram of a structure of a chip package structure according to another implementation not covered by the present invention but useful for its understanding;
FIG. 4 is a schematic diagram of a structure of a chip package structure according to another implementation of this invention;
FIG. 5 is a schematic diagram of a structure of a chip package structure according to another implementation of this invention;
FIG. 6 is a step flowchart of a chip package method according to an embodiment not falling within the invention; and
FIG. 7 to FIG. 15 are schematic diagrams of structures of chip package structures in steps of the chip package method shown in FIG. 6.

### DESCRIPTION OF EMBODIMENTS

The following specifically describes implementations of this invention with reference to accompanying drawings in the implementations of this invention.

In an aspect, the invention provides an electronic device, and the electronic device may be an electronic product such as a headset, a mobile phone, a tablet computer, a wearable watch, or a router. The electronic device includes a chip that can implement various functions. Taking a mobile phone as an example, the mobile phone may include various types of chips, such as a central processing chip that invokes electronic device instructions to enable the electronic device to perform corresponding operations, a storage chip used for data storage, a radio frequency chip used for processing radio frequency signals, and an audio chip used for processing audio signals. The chips are electrically connected to other structures in the electronic device, so as to perform related functions. It should be noted that each chip in the electronic device is packaged in a chip package structure, so as to prevent a circuit of the chip from being corroded by external impurities, and to facilitate installation and transportation of the chip. Therefore, in the electronic device of this invention, the chip package structure is electrically connected to another structure of the electronic device, so that the chip is electrically connected to the another structure of the electronic device. Specifically, some electronic devices include circuit boards. By installing a package chip on a circuit board (a rigid circuit board or a flexible circuit board), and then connecting the circuit board to another structure in the electronic device, signal transmission between the chip package structure and the another structure in the electronic device may be implemented by using a connection between the chip package structure and the another structure in the electronic device through a cable of the circuit board. For example, a chip package structure in which an audio chip is packaged is installed on a circuit board, and then the circuit board is connected to a structure such as a microphone or a speaker of an electronic device, so that audio information received by the microphone can be transmitted to the audio chip, and the audio information may be stored after being processed by the audio chip. Alternatively, the stored audio information is transmitted to the speaker for playback after being processed by the audio chip.

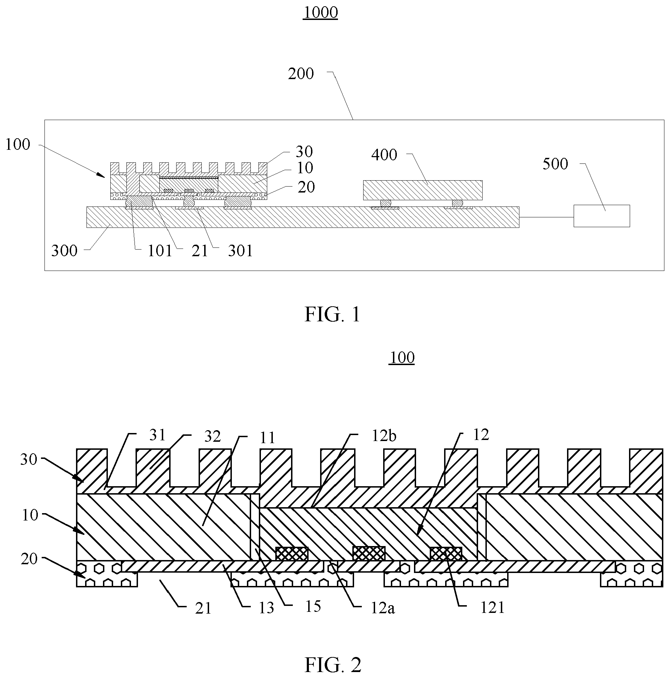

FIG. 1 is a cross sectional schematic view of an electronic device 1000 according to some implementations of this invention In this implementation, the electronic device 1000 is a mobile phone. The electronic device 1000 includes a housing 200, and at least one chip package structure 100 and a main board 300 that are disposed in the housing 200. The chip package structure 100 is installed on the main board 300. The main board 300 is a circuit board. At least one chip package structure 100 is installed on the main board 300, and the chip package structure 100 is connected, by using a circuit on the main board 300, to another component 400 integrated on the main board 300 to form a processing circuit. The another component 400 may be a component such as a capacitor, an inductor, or a resistor. Alternatively, the main board 300 is connected to another structure 500 of the electronic device 1000, so as to implement signal transmission between the chip package structure 100 and the another structure 500 of the electronic device 1000. The another structure 500 of the electronic device 1000 may be a microphone, a speaker, a display, a touch layer, an antenna, or the like. The chip package structure 100 is electrically connected to different structures to implement different functions of chips based on different types of chips packaged in the chip package structure 100.

FIG. 2 is a schematic diagram of a structure of a chip package structure 100 according to an implementation not covered by the present invention but useful for its understanding. The chip package structure 100 includes a packaging layer 10, an insulation layer 20, and a heat sink 30 that are sequentially laminated. In this implementation, the packaging layer 10 includes a packaging substrate 11, a chip 12, and an electrode cable 13. The chip 12 is embedded in the packaging substrate 11, and the packaging substrate 11 is used to protect the chip 12. The packaging substrate 11 may be formed of an insulation material such as resin.

In this implementation, an accommodating cavity 14 is disposed on the packaging substrate 11, and the accommodating cavity 14 penetrates the packaging substrate 11. It may be understood that, in some other implementations, the accommodating cavity 14 may not penetrate the packaging substrate 11. For example, the accommodating cavity 14 may be a groove recessed from one surface of the packaging substrate 11 to the other surface. The chip 12 is accommodated in the accommodating cavity 14, and a gap between the chip 12 and an inner wall of the accommodating cavity 14 is filled with an insulation material 15, so that the chip 12 can be stably fixed in the accommodating cavity 14. In some implementations, the insulation material 15 filled in the gap between the chip 12 and the inner wall of the accommodating cavity 14 may be a thermally conductive insulation material, so that heat generated when the chip 12 works can be transmitted by using the thermally conductive insulation material, thereby improving heat dissipation efficiency in the chip 12. For example, the thermally conductive insulation material may be thermally conductive resin, molding materials, or the like. In some implementations, the insulation material 15 filled in the gap between the chip 12 and the inner wall of the accommodating cavity 14 may be a same material as that of the packaging substrate 11. When the insulation material 15 is filled in the gap between the chip 12 and the inner wall of the accommodating cavity 14, the insulation material 15 can be integrated with the packaging substrate 11. Because the insulation material 15 and the packaging substrate 11 are the same material, combination between the insulation material 15 and the inner wall of the accommodating cavity 14 is more stable, and separation between them because of a temperature change or external force can be avoided, thereby ensuring service life of the chip package structure 100.

In this invention, there may be one or more chips 12 in the chip package structure 100. When there are a plurality of chips 12 in the chip package structure 100, that is, when a plurality of chips 12 are packaged in a same package structure, packaging steps can be reduced, production costs can be reduced, and a volume occupied by the chip 12 after being packaged can be reduced. When there are a plurality of chips 12 in the chip package structure 100, the plurality of chips 12 may be disposed side by side or laminated in a thickness direction of the chip 12. When the plurality of chips 12 on the chip package structure 100 are disposed side by side, a plurality of accommodating cavities 14 are disposed side by side at intervals on the packaging substrate 11, and each chip 12 is disposed in one accommodating cavity 14 correspondingly. When the plurality of chips 12 in the chip package structure 100 are laminated, a thickness of the packaging substrate 11 may be relatively large, so that the plurality of chips 12 can be accommodated in a same accommodating cavity 14 after being laminated, and an area occupied by the chip package structure 100 can be reduced while package steps of the chip 12 are reduced.

The chip 12 includes a first side 12a and a second side 12b that are disposed opposite to each other. Specifically, a side where an active region is located in the chip 12 is the first side 12a of the chip 12 in this implementation. The chip 12 includes an electrode used to lead out a signal or introduce a signal into the chip 12. In the implementation shown in FIG. 2, the electrode includes a first electrode 121 disposed on the first side 12a of the chip 12. The first electrode 121 is connected to the electrode cable 13, and a signal can be transmitted to the chip 12 sequentially through the electrode cable 13 and the first electrode 121, or a signal in the chip 12 can be output sequentially through the first electrode 121 and the electrode cable 13. A quantity of first electrodes 121 may be set to one or more based on an actual situation. In some implementations, there are three first electrodes 121 of the chip 12. The three first electrodes 121 are electrically connected to a gate, a source, and a drain of a transistor in the chip 12 respectively, and different signals are input into the three first electrodes 121, so as to drive the chip 12 to work. In another implementation, there may be more first electrodes 121 of the chip 12. For example, when transistors with a plurality of functions are integrated in the chip 12, there may be more first electrodes 121 in the chip 12, and the first electrodes 121 are used to transmit more different signals, so as to drive the chip 12 to implement different functions.

The insulation layer 20 is formed of an insulation material, and the insulation layer 20 is laminated on one side of the packaging layer 10 and covers the electrode cable 13, so as to protect the electrode cable 13 by using the insulation layer 20, so that a problem that electrical performance of the electrode cable 13 is deteriorated due to corrosion can be avoided, and interference from the outside to signal transmission can be avoided.

An opening 21 is disposed on the insulation layer 20, and the opening 21 is disposed corresponding to the electrode cable 13 to expose a part of the electrode cable 13. When the chip package structure 100 is electrically connected to the circuit board, a part of electrode cable 13 exposed at a position of the opening 21 may be electrically connected to the circuit board by using a solder ball or a soldering tin, so that the chip package structure 100 is installed and fixed on the circuit board, and the chip package structure 100 is electrically connected to a cable of the circuit board. As shown in FIG. 1, the chip package structure 100 is soldered to a solder pad 301 of the main board 300 by using a solder ball 101, so that the chip package structure 100 is electrically connected to the main board 300. In an implementation, by designing a cable of the electrode cable 13, the first electrode 121 may be extended to a required position or the opening 21 is created at a required position by using the electrode cable 13 based on a type of a circuit board on which the chip package structure 100 needs to be installed. Therefore, when the chip package structure 100 is electrically connected to the circuit board, a position of the opening 21 on the insulation layer 20 of the chip package structure 100 is corresponding to the solder pad of the circuit board, that is, the part of the electrode cable 13 that exposes the opening 21 is corresponding to the solder pad of the circuit board, so that the chip package structure 100 can be conveniently connected to various types of circuit boards. In other words, in this implementation, the first electrode 121 of the chip 12 is led out by using the electrode cable 13, and therefore an extension position of the electrode cable 13 and the position of the opening 21 on the insulation layer 20 can be adjusted based on a type of a circuit board on which the chip package structure 100 is installed, so that the chip package structure 100 can be flexibly applied to various types of circuit boards.

In some implementations, the insulation layer 20 may be liquid photoimagable solder mask (that is, solder mask), which can protect the electrode cable 13, achieve an insulation effect, and play the role of solder resist. When the part of the electrode cable 13 exposed at the position of the opening 21 is electrically connected to the circuit board by using a solder ball or a soldering tin, solder may be easily concentrated at the position of the opening 21 on the insulation layer 20, thereby improving a yield of soldering. It may be understood that, in another implementation, the insulation layer 20 may alternatively be another type of insulation material such as resin.

In this invention, the chip package structure 100 includes the heat sink 30, and the heat sink 30 is configured to dissipate heat for the chip 12 disposed on the packaging layer 10. In this invention, the heat sink 30 is laminated on a side that is of the packaging layer 10 and that is away from the insulation layer 20, and the heat sink 30 is integrated with the packaging layer 10. Specifically, that the heat sink 30 is integrated with the packaging layer 10 means that the heat sink 30 can be directly formed on the packaging layer 10 by using a process such as electroplating or lamination, and that the pre-formed heat sink 30 does not need to be fixed to the packaging layer 10 in a manner such as soldering, gluing, or using a fastener. Compared with fixing the pre-formed heat sink 30 to the packaging layer 10 in a manner such as soldering, gluing, or using a fastener, a defect such as a hole does not easily occur at a position at which the heat sink 30 is fixed to the packaging layer 10, so that heat of the packaging layer 10 can be transmitted to the heat sink 30 more efficiently, thereby implementing a better heat dissipation effect, and ensuring that there can be higher combination strength between the heat sink 30 and the packaging layer 10. In addition, in this invention, the heat sink 30 may be directly formed on the packaging layer 10 through electroplating or various molding processes, and the formed heat sink 30 does not need to be fixed to the packaging layer 10 in a fixing manner such as soldering, gluing, or using a fastener. Therefore, a manufacturing process can be reduced, thereby reducing production costs and improving production efficiency.

In the implementation of FIG. 2, the packaging layer 10 includes only the packaging substrate 11, the chip 12 disposed in the accommodating cavity 14 of the packaging substrate 11, and the electrode cable 13 of the first electrode 121 connected to the chip 12. The heat sink 30 is laminated on a side that is of the packaging layer 10 and that is away from the insulation layer 20, that is, the heat sink 30 is laminated on a side that is of the packaging substrate 11 and that is away from the insulation layer 20. In this implementation, when the first side 12a of the chip 12 is connected to the electrode cable 13, and the second side 12b of the chip 12 is connected to the heat sink 30, the heat sink 30 is in direct contact with the second side 12b of the chip 12, so that heat generated when the chip 12 works can be directly and quickly transmitted to the heat sink 30 and dissipated.

In some implementations, the heat sink 30 is a metal mechanical part, and is formed on the packaging layer 10 in an electroplating manner, so that the heat sink 30 is integrated with the packaging layer 10. Metal may have a relatively high thermal conductivity coefficient, so that heat of the chip 12 can be rapidly transmitted, thereby implementing a good thermal conductivity effect. In some implementations, the heat sink 30 includes a metal sheet 31, and the metal sheet 31 is formed in the packaging layer 10 through electroplating. In some implementations, a surface 211 that is of the metal sheet 31 and that is away from the packaging layer 10 may be an uneven surface, such as a serrated surface or a wavy surface, so that a heat dissipation area in which the metal sheet 31 performs heat exchange with the outside can be increased, and heat dissipation efficiency of the heat sink 30 can be improved.

In some implementations, the heat sink 30 further includes a plurality of heat dissipation fins 32, where the heat dissipation fins 32 are formed on a side that is of the metal sheet 31 and that is away from the packaging layer 10, and there are gaps among the heat dissipation fins 32. The heat dissipation fins 32 are disposed on the side that is of the metal sheet 31 and that is away from the packaging layer 10, to increase the heat dissipation area in which the heat sink 30 performs heat exchange with the outside, thereby improving heat dissipation efficiency of the heat sink 30. Shapes and arrangement manners of the plurality of heat dissipation fins 32 may be randomly changed. For example, in some implementations, the heat dissipation fins 32 of the heat sink 30 are strip-shaped, and the plurality of heat dissipation fins 32 are disposed side by side at intervals in a direction perpendicular to a direction in which the heat dissipation fins 32 extend. In some implementations, the heat dissipation fins 32 of the heat sink 30 are columnar or block-shaped, and the plurality of heat dissipation fins 32 are arranged in an array. In some implementations, the heat dissipation fins 32 of the heat sink 30 are strip-shaped, one end of each heat dissipation fin 32 is connected, and the other end extends radially in each direction. It may be understood that, in this invention, shapes and arrangement manners of the heat dissipation fins 32 may be other types, which are not listed herein. In some other implementations, the heat sink 30 may alternatively include only the heat dissipation fin 32, and the heat dissipation fin 32 is directly formed on a surface of the packaging layer 10.

It may be understood that, in some other implementations, the heat sink 30 may alternatively be of another structure. For example, the heat sink 30 may be an air cooling tube. The air cooling tube is of a tubular structure and includes an air intake vent and an air exhaust vent that are disposed opposite to each other. Cooling air enters from the air intake vent, flows in the air cooling tube 24, absorbs heat transmitted from the chip 12 to the heat sink 30, and then exits the air from the air exhaust vent. In some implementations, a fan is disposed at the air intake vent, increase air flow efficiency in the air cooling tube, thereby improving heat exchange efficiency between air in the air cooling tube and a heat dissipation wall, and further improving heat dissipation efficiency of the chip package structure 100.

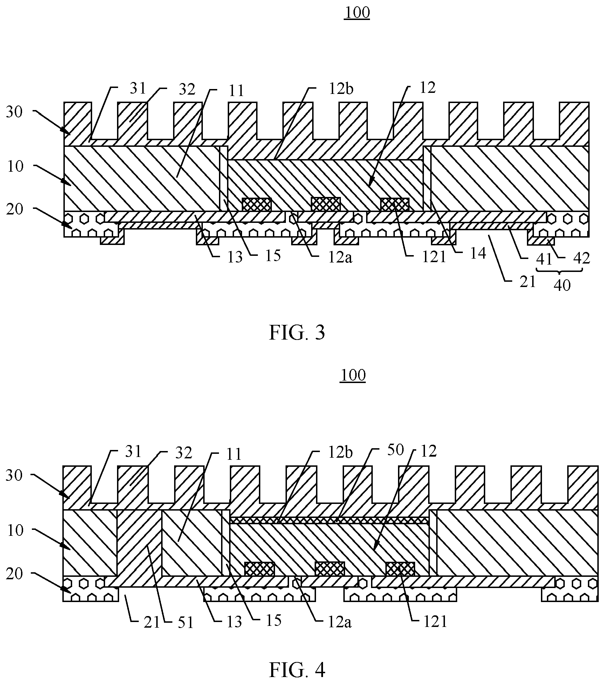

FIG. 3 is a schematic diagram of a structure of a chip package structure 100 according to another implementation not covered by the present invention but useful for its understanding. A difference between this implementation and the implementation shown in FIG. 1 lies in that the chip package structure 100 of this implementation further includes a soldering washer 40. The soldering washer 40 is a metal washer, and a size of the soldering washer 40 is slightly greater than a size of the opening 21 of the insulation layer 20. The soldering washer 40 is partially in contact with an area in which the opening 21 is exposed. Specifically, the soldering washer 40 includes a first part 41 and a second part 42 that are connected, where the first part 41 covers an area in which the electrode cable 13 exposes the opening 21, and the second part 42 covers a peripheral edge of the opening 21 of the insulation layer 20. In this implementation, a relatively large soldering washer 40 is formed at the position of the opening 21 of the insulation layer 20, and the first part 41 of the soldering washer 40 is connected to the area in which the electrode cable 13 exposes the opening 21, so that a size of a pin when the chip package structure 100 is electrically connected to the circuit board can be increased, and the chip package structure 100 can be more easily and stably electrically connected to the solder pad of the circuit board. In addition, the soldering washer 40 partially covers the peripheral edge of the opening 21 of the insulation layer 20, that is, the soldering washer 40 partially covers the insulation layer 20. Therefore, compared with a manner of fixing the solder ball or the soldering tin to the electrode cable 13 through the opening 21 of the insulation layer 20, the solder ball or the soldering tin can implement an electrical connection between the chip package structure 100 and the circuit board without needing to be connected to the electrode cable 13 through the opening 21. That is, the soldering washer 40 can be welded to the solder pad of the circuit board more easily, so that the chip package structure 100 can be electrically connected to the circuit board more easily, and a connection yield is higher.

FIG. 4 is a schematic diagram of a structure of a chip package structure 100 according to an implementation of this invention. A difference between this implementation and the implementation shown in FIG. 2 lies in that in accordance with the invention, the chip package structure 100 further includes a metal layer 50 that covers the second side 12b of the chip 12, and the metal layer 50 is electrically connected to the electrode cable 13. Specifically, in this implementation, a via 51 is disposed on the packaging substrate 11, and the metal layer 50 is electrically connected to the electrode cable 13 through the via 51. It may be understood that, in some other implementations of this invention, a cavity wall of the accommodating cavity 14 may form a metal connection layer, and the metal layer 50 is electrically connected to the electrode cable 13 through the metal connection layer. In this implementation, heat generated on the first side 12a of the chip 12 can be transmitted to the heat sink 30 sequentially through the first electrode 121, the electrode cable 13, and the via 51, and then be dissipated by using the heat sink 30, to avoid a problem that heat generated on the first side 12a of the chip 12 cannot be rapidly dissipated, thereby affecting performance of the chip 12. In addition, the first side 12a of the chip 12 is connected to the second side 12b by using the first electrode 121, the electrode cable 13, the via 51, and the metal layer 50, so that heat generated on two sides of the chip 12 can be transmitted to each other, heat at each position of the chip 12 can be relatively evenly distributed, and heat aggregation at a specific position of the chip 12 can be avoided to affect performance of the chip. It should be noted that the via 51 that passes through the packaging layer 10 in this invention refers to a structure formed by filling a through hole that is disposed on the packaging layer 10 with a metal material. In some implementations, a metal rod may be formed first, and then the metal rod is embedded in the packaging layer 10. The metal rod is the via 51 described in this invention.

In this implementation, because the metal layer 50 is laminated on the second side 12b of the chip 12, when the heat sink 30 is laminated on the packaging substrate 11, the heat sink 30 can be in direct contact with the metal layer 50. That is, the heat sink 30 implements indirect contact with the chip 12 by using the metal layer 50, so that heat generated when the chip 12 works can be rapidly transmitted to the heat sink 30 by using the metal layer 50. In addition, the metal layer 50 is laminated on the second side 12b of the chip 12, and therefore the heat sink 30 can be formed on a side of the chip 12 in an electroplating manner more easily, and a better electroplating effect is implemented, so that a combination of the heat sink 30 and the chip 12 is more stable, and heat of the chip 12 can be transmitted to the heat sink 30 more efficiently. In addition, in this implementation, because the via 51 is a structure that passes through the packaging substrate 11, the heat sink 30 can also be in direct contact with the via 51. That is, in this implementation, the via 51 can be electrically connected to the metal layer 50 by using the heat sink 30, and the electrode cable 13 and the heat sink 30 are respectively connected to two ends of the via 51, so that the metal layer 50 can be electrically connected to the electrode cable 13 by using the heat sink 30 and the via 51. In some implementations, a cable may be disposed on a surface that is of the packaging substrate 11 and that faces the heat sink 30, and the metal layer 50 is electrically connected to the via 51 by using the cable.

In some implementations, the chip package structure 100 in the implementation shown in FIG. 4 also includes the soldering washer 40 of the chip package structure 100 in the implementation shown in FIG. 3. A disposing manner and a structure of the chip package structure are the same as those in the implementation shown in FIG. 4. Details are not described herein again.

In some implementations, the chip 12 further includes a second electrode disposed on the second side 12b, and the metal layer 50 is the second electrode, that is, the second electrode of the chip covers the second side of the chip 12, and is electrically connected to the electrode cable 13 by using the via 51. For example, when the chip 12 includes a transistor configured to process a plurality of functions, there is a relatively large quantity of electrodes in the chip 12, and some electrodes in the chip 12 may be disposed on the second side 12b of the chip 12, so as to ensure a signal transmission effect. Alternatively, when the chip 12 is a high-power chip, a second electrode is disposed on the second side 12b, so that heat generated when the chip 12 works can be dissipated from the first side 12a and the second side 12b of the chip 12 faster, thereby realizing a better heat dissipation effect. In some other implementations, not being covered by the present invention, the metal layer 50 may not be used as the second electrode of the chip 12. The second electrode of the chip 12 is located on the second side 12b of the chip 12, and contacts the metal layer 50 to perform electrical connection.

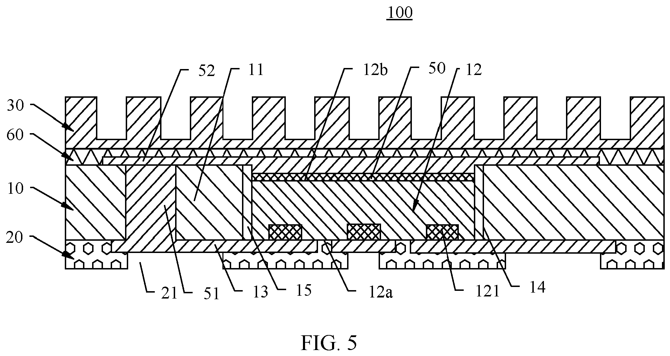

FIG. 5 is a schematic diagram of a structure of a chip package structure 100 according to another implementation of this invention. A difference between this implementation and the implementation shown in FIG. 4 lies in that in this implementation, the chip package structure 100 further includes a thermally conductive insulation layer 60. The thermally conductive insulation layer 60 covers the packaging layer 10, and the heat sink 30 is located on a side that is of the thermally conductive insulation layer 60 and that is away from the packaging substrate 11, so that the chip 12 is separated from the heat sink 30 by using the thermally conductive insulation layer 60. That is, the thermally conductive insulation layer 60 indirectly contacts the second side 12b of the chip 12 by using the metal layer 50. When the chip 12 is a high-power chip, that is, when a voltage transmitted to the chip 12 is relatively high, the chip 12 is separated from the heat sink 30 by using the thermally conductive insulation layer 60 to avoid a safety risk caused by a leakage of power from the chip 12. In addition, in this implementation, a cable 52 is disposed on the surface that is of the packaging substrate 11 and that faces the heat sink 30, and the metal layer 50 is electrically connected to the via 51 by using the cable 52.

The thermally conductive insulation layer 60 may be one or more of thermally conductive silica gel, thermally conductive silicone grease, thermally conductive resin, or another type of thermally conductive material. In this implementation, the thermally conductive insulation layer 60 is thermally conductive resin, and the thermally conductive insulation layer 60 is formed by adding an insulating filler with relatively high thermal conductivity efficiency to a resin material. Specifically, the insulating filler may be a material such as alumina ceramic or quartz sand. In this implementation, the thermally conductive insulation layer 60 is formed on one side of the packaging substrate by using a lamination process, so that the thermally conductive insulation layer 60 is integrated with the packaging substrate, and a combination between the thermally conductive insulation layer 60 and the packaging substrate is more stable. In addition, defects at a position at which the thermally conductive insulation layer 60 and the packaging substrate are combined can be reduced, so that heat of the chip 12 can be efficiently transmitted to the thermally conductive insulation layer 60. The heat sink 30 is formed on a surface that is of the thermally conductive insulation layer 60 and that is away from the packaging substrate 11 in an electroplating manner, so that the heat sink 30 can be integrated with the thermally conductive insulation layer 60, and a combination between the thermally conductive insulation layer 60 and the heat sink 30 is more stable. In this way, defects at a position at which the thermally conductive insulation layer 60 and the heat sink 30 are combined can be reduced, so that heat transmitted to the thermally conductive insulation layer 60 can be efficiently transmitted to the heat sink 30 and then dissipated efficiently.

In this invention, by designing a cable of the electrode cable 13, the first electrode 121 may be extended to a required position or an opening 21 is created at a required position by using the electrode cable 13 based on a type of a circuit board on which the chip package structure 100 needs to be installed. Therefore, when the chip package structure 100 is electrically connected to the circuit board, a position of the opening 21 of the insulation layer 20 of the chip package structure 100 is corresponding to a solder pad of the circuit board, that is, the part of the electrode cable 13 that exposes the opening 21 is corresponding to the solder pad of the circuit board, so that the chip package structure 100 can be conveniently connected to various types of circuit boards. In other words, in this invention, the first electrode 121 of the chip 12 is led out by using the electrode cable 13, and therefore an extension position of the electrode cable 13 and the position of the opening 21 on the insulation layer 20 can be adjusted based on a type of a circuit board on which the chip package structure 100 is installed, so that the chip package structure 100 can be flexibly applied to various types of circuit boards.

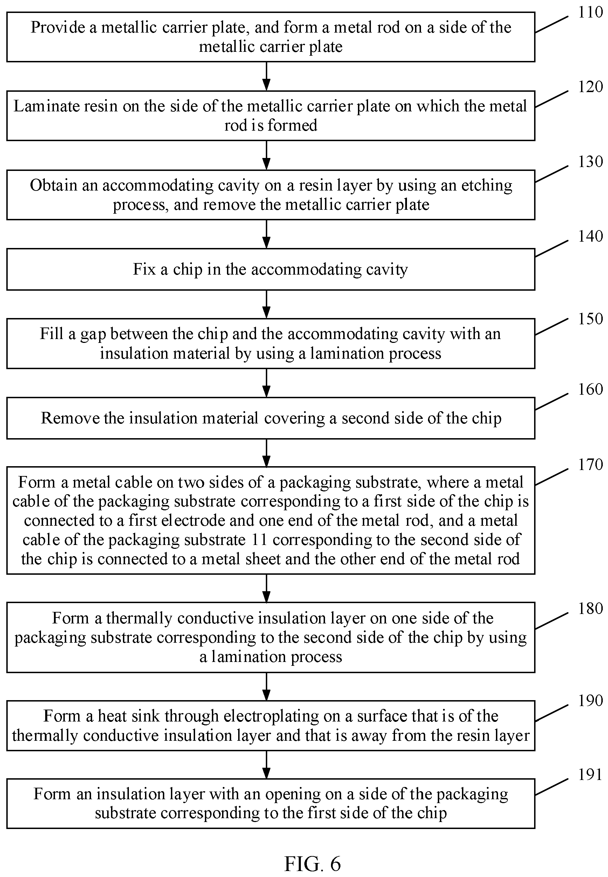

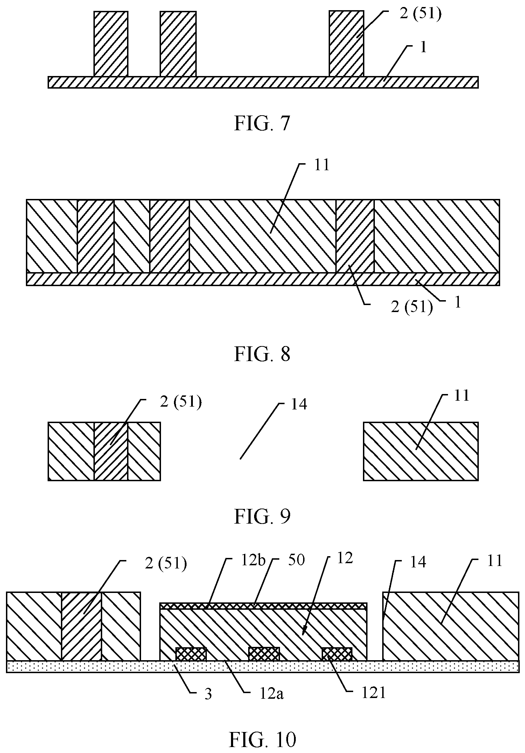

This specification further provides a chip package method, and the chip package method is used to package a chip to obtain the foregoing chip package structure 100. FIG. 6 is a step flowchart of a chip package method according to an embodiment not belonging to the invention. The chip package method provided in this specification mainly includes the following steps:
Referring to FIG. 7, provide a metallic carrier plate 1, and form a metal rod 2 on a side of the metallic carrier plate 1.

In this implementation, the metal rod 2 is formed on one side of the metallic carrier plate 1 in an electroplating manner. Specifically, a dry film covers a surface of the metallic carrier plate 1, and the dry film is hollowed out corresponding to a position where the metal rod 2 needs to be formed through electroplating on the metallic carrier plate 1. Then, the surface of the metallic carrier plate 1 is electroplated, and the metal rod 2 is formed through electroplating in an area not covered by the dry film. In this implementation, both the metallic carrier plate 1 and the metal rod 2 are made of a copper material with good electrical and thermal conductivity. It may be understood that, in another implementation of this invention, the metallic carrier plate 1 and the metal rod 2 may alternatively be made of another metal material.

Referring to FIG. 8, laminate resin on a side of the metallic carrier plate 1 on which the metal rod 2 is formed.

Specifically, a resin layer is formed, by using a lamination process, on the side of the metallic carrier plate 1 on which the metal rod 2 is formed. The obtained resin layer is the packaging substrate 11 of the chip package structure 100 in this invention, and the metal rod 2 is the via 51 of the chip package structure 100 in this invention. In some implementations, when the laminated resin covers the metal rod 2, a part of the resin is ground away by using a grinding process, so as to expose the metal rod 2.

Referring to FIG. 9, obtain an accommodating cavity 14 on the resin layer by using an etching process, and remove the metallic carrier plate 1. The accommodating cavity 14 penetrates the resin layer.

Referring to FIG. 10, fix a chip 12 in the accommodating cavity 14. Specifically, an adhesive tape 3 is attached to one surface of the resin layer, and the adhesive tape 3 covers one end of the accommodating cavity 14. The chip 12 is disposed in the accommodating cavity 14 and attached to the adhesive tape 3, so as to position the chip 12 in the accommodating cavity 14 by using the adhesive tape 3. In this implementation, a first side 12a of the chip 12 is attached to the adhesive tape 3. In some implementations, a metal layer 50 is pre-formed on a second side 12b of the chip 12. When the metal layer 50 is a second electrode of the chip 12, the metal layer 50 is formed in a production process of the chip 12. When the metal layer 50 is not the second electrode of the chip 12, the metal layer 50 needs to be pre-formed on the second side 12b of the chip 12 in a manner such as magnetron sputtering or vapor deposition.

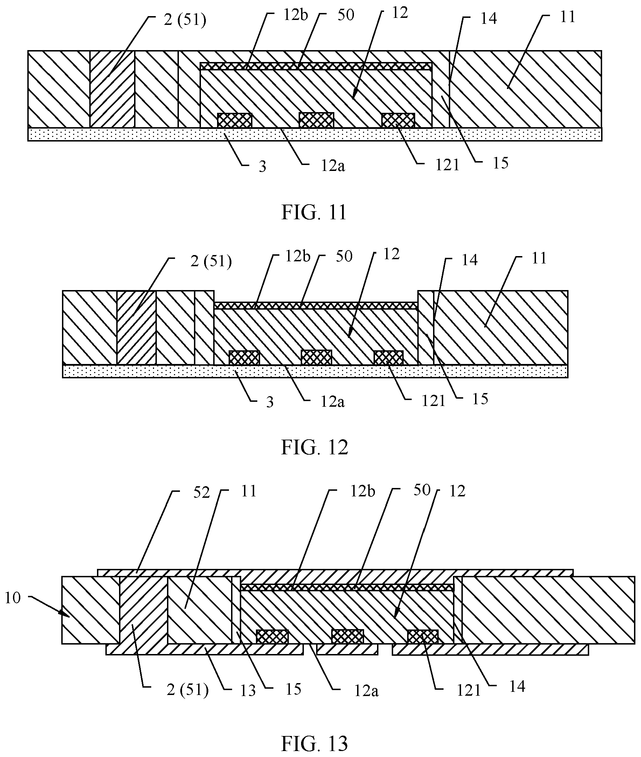

150: Referring to FIG. 11, fill a gap between the chip 12 and the accommodating cavity 14 with an insulation material 15 by using a lamination process. In this implementation, the insulation material 15 filled in the gap between the chip 12 and the accommodating cavity 14 is a resin material that is the same as the resin layer. In some implementations, the insulation material 15 filled in the gap between the chip 12 and the accommodating cavity 14 may be a thermally conductive insulation material, such as thermally conductive resin, thermally conductive silicone grease, thermally conductive silica gel, and thermally conductive rubber.

160: Referring to FIG. 12, remove an insulation material covering the second side 12b of the chip 12. Specifically, the insulation material covering the second side 12b of the chip 12 in step 150 may be removed by using a grinding process or an etching process.

170: Referring to FIG. 13, form a metal cable on two sides of the packaging substrate 11, where a metal cable of the packaging substrate 11 corresponding to a first side 12a of the chip 12 is connected to a first electrode 121 and one end of the metal rod 2, and a metal cable of the packaging substrate 11 corresponding to a second side 12b of the chip 12 is connected to a metal sheet 50 and the other end of the metal rod 2. A metal cable connected to the first electrode 121 of the chip 12 is an electrode cable 13 of this invention, and a metal cable connected to the metal sheet 50 of the chip 12 is a cable 52 of this invention.

It should be noted that in this step, the first electrode 121 can be directly formed on a side of the packaging substrate 11 on the first side 12a of the chip 12, the heat sink 30 is directly formed on a side of the packaging substrate 11 corresponding to the second side 12b of the chip 12 by using an electroplating process, and the insulation layer 20 with the opening 21 is formed on a side of the packaging substrate 11 corresponding to the first side 12a of the chip 12, to obtain the chip package structure 100 shown in FIG. 4.

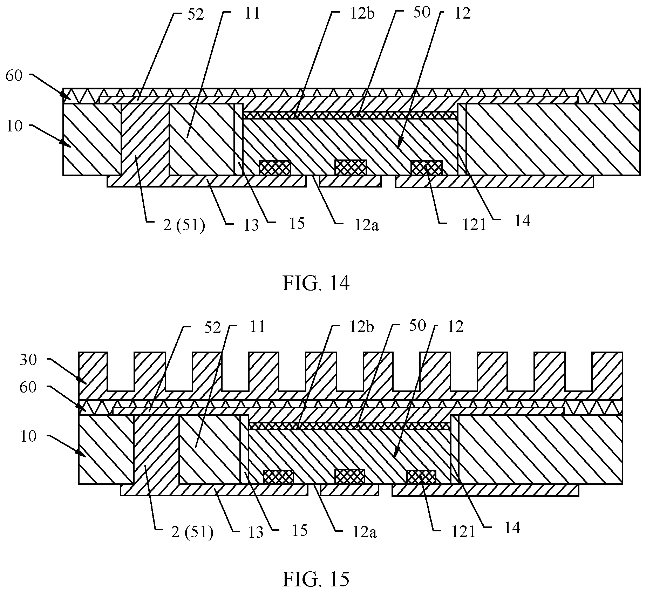

Referring to FIG. 14, form a thermally conductive insulation layer 60 on one side of the packaging substrate 11 corresponding to the second side 12b of the chip 12 by using a lamination process.

Referring to FIG. 15, form a heat sink 30 through electroplating on a surface that is of the thermally conductive insulation layer 60 and that is away from the resin layer. Specifically, an electroplated seed layer is first formed on the surface that is of the thermally conductive insulation layer 60 and that is away from the resin layer in a manner such as vapor deposition, magnetron sputtering, or electroless copper plating, and then the heat sink 30 is formed on a basis of the electroplated seed layer by using an electroplating process. In some implementations, a manner of forming the heat sink 30 on the surface that is of the thermally conductive insulation layer 60 and that is away from the resin layer may be an injection molding manner, or the like.

Referring to FIG. 5, form an insulation layer 20 with an opening 21 on a side of the packaging substrate 11 corresponding to the first side 12a of the chip 12. The opening 21 corresponds to a part of the electrode cable 13, and the chip package structure 100 in the implementation shown in FIG. 5 of this invention is obtained. Specifically, the insulation layer 20 may be formed in a manner of spraying, ink jet printing, or the like.

In the foregoing chip package method, the heat sink 30 is directly formed on the packaging substrate 11 or the thermally conductive insulation layer 60 in an electroplating manner, an injection molding manner, or the like, so that the heat sink 30 is integrated with the packaging substrate 11 or the thermally conductive insulation layer 60. Compared with fixing the heat sink 30 to the packaging layer 10 in a manner such as soldering, gluing, or using a fastener, a defect such as a hole does not easily occur at a position at which the heat sink 30 is combined with the packaging layer 10, so that heat of the packaging layer 10 can be transmitted to the heat sink 30 more efficiently, thereby implementing a better heat dissipation effect, and ensuring that there can be higher combination strength between the heat sink 30 and the packaging layer 10. In addition, in this invention, the heat sink 30 may be directly formed on the packaging layer 10 through electroplating or various molding processes, and the formed heat sink 30 does not need to be fixed to the packaging layer 10 in a fixing manner such as soldering, gluing, or using a fastener. Therefore, a manufacturing process can be reduced, thereby reducing production costs and improving production efficiency. In addition, in this invention, an extension position of the electrode cable 13 and the position of the opening 21 on the insulation layer 20 can be adjusted based on a type of a circuit board on which the chip package structure 100 is installed, so that the chip package structure 100 can be flexibly applied to various types of circuit boards.

It should be noted that the foregoing are only specific implementations of this invention, but the protection scope of this invention is not limited thereto . Therefore, the protection scope of this invention shall be determined by the claims.

## Claims

1. A chip package structure (100), comprising an insulation layer (20), a packaging layer (10), and a heat sink (30) that are sequentially laminated, wherein the packaging layer comprises a packaging substrate (11), a chip (12), and an electrode cable (13), the chip is embedded in the packaging substrate, the chip comprises a first side and a second side that are disposed opposite to each other, the chip comprises a first electrode (121) disposed on the first side, and the electrode cable is formed on a surface of the packaging substrate and is electrically connected to the first electrode; the insulation layer covers the electrode cable, an opening (21) is disposed on the insulation layer, and the opening is disposed corresponding to the electrode cable to expose a part of the electrode cable; and the heat sink is integrated with the packaging layer, wherein the second side of the chip is covered with a metal layer (50),
**characterized in that** the metal layer is electrically connected to the electrode cable and the chip comprises a second electrode disposed on the second side, and the metal layer is the second electrode.

2. The chip package structure according to claim 1, wherein the packaging substrate (11) comprises an accommodating cavity (14), the chip (12) is accommodated in the accommodating cavity, there is a gap between the chip and the accommodating cavity, and the gap is filled with a thermally conductive insulation material (15).

3. The chip package structure according to claim 2, wherein the heat sink : (30) is laminated on the packaging substrate (11) and is integrated with the packaging substrate, and the heat sink is in contact with the second side of the chip (12).

4. The chip package structure according to any one of claims 1 to 2, wherein the chip package structure further comprises a thermally conductive insulation layer (60), and the thermally conductive insulation layer covers the packaging layer (10), the heat sink (30) is located on a side that is of the thermally conductive insulation layer and that is away from the packaging layer, and the heat sink is integrated with the thermally conductive insulation layer; and the thermally conductive insulation layer is in indirect contact with the second side of the chip (12).

5. The chip package structure according to claim 1, wherein the chip package structure further comprises a soldering washer (40); the soldering washer comprises a first part and a second part that are connected; and the first part covers an area in which the electrode cable (13) exposes the opennig (21), and the second part covers a peripheral edge of the opening of the insulation layer (20).

6. The chip package structure according to claim 1, wherein the heat sink comprises a metal sheet (31), and the metal sheet is formed in the packaging layer (10) through electroplating

7. The chip package structure according to claim 6, wherein the heat sink (30) further comprises a plurality of heat dissipation fins (32), the heat dissipation fins are formed on a side that is of the metal sheet (31) and that is away from the packaging layer (10), and there are gaps among the heat dissipation fins.

8. An electronic device (1000), comprising a circuit board (300) and the chip package structure according to any one of claims 1 to 7, wherein a part of the electrode cable (13) that exposes the opening (21) in the chip package structure is electrically connected to the circuit board.

## Patentansprüche

1. Chip-Verpackungsstruktur (100), umfassend eine Isolationsschicht (20), eine Verpackungsschicht (10) und eine Wärmesenke (30), die aufeinanderfolgend laminiert sind, wobei die Verpackungsschicht ein Verpackungssubstrat (11), einen Chip (12) und ein Elektrodenkabel (13) umfasst, der Chip in das Verpackungssubstrat eingebettet ist, der Chip eine erste Seite und eine zweite Seite umfasst, die einander gegenüberliegend angeordnet sind, der Chip eine erste Elektrode (121) umfasst, die auf der ersten Seite angeordnet ist, und das Elektrodenkabel auf einer Oberfläche des Verpackungssubstrats ausgebildet ist und elektrisch mit der ersten Elektrode verbunden ist; die Isolierschicht das Elektrodenkabel bedeckt, eine Öffnung (21) auf der Isolierschicht angeordnet ist und die Öffnung entsprechend dem Elektrodenkabel angeordnet ist, um einen Teil des Elektrodenkabels freizulegen; und die Wärmesenke in die Verpackungsschicht integriert ist, wobei die zweite Seite des Chips mit einer Metallschicht (50) bedeckt ist, **dadurch gekennzeichnet, dass** die Metallschicht elektrisch mit dem Elektrodenkabel verbunden ist und der Chip eine zweite Elektrode umfasst, die auf der zweiten Seite angeordnet ist, und die Metallschicht die zweite Elektrode ist.

2. Chipverpackungsstruktur nach Anspruch 1, wobei das Verpackungssubstrat (11) einen Aufnahmehohlraum (14) umfasst, der Chip (12) in dem Aufnahmehohlraum aufgenommen ist, eine Lücke zwischen dem Chip und dem Aufnahmehohlraum vorhanden ist und die Lücke mit einem wärmeleitenden Isoliermaterial (15) gefüllt ist.

3. Chip-Verpackungsstruktur nach Anspruch 2, wobei die Wärmesenke (30) auf das Verpackungssubstrat (11) laminiert ist und mit dem Verpackungssubstrat integriert ist und die Wärmesenke in Kontakt mit der zweiten Seite des Chips (12) steht.

4. Chip-Verpackungsstruktur nach einem der Ansprüche 1 bis 2, wobei die Chip-Verpackungsstruktur ferner eine wärmeleitende Isolierschicht (60) umfasst und die wärmeleitende Isolierschicht die Verpackungsschicht (10) bedeckt, die Wärmesenke (30) auf einer Seite angeordnet ist, die zu der wärmeleitenden Isolierschicht gehört und die von der Verpackungsschicht abgewandt ist, und die Wärmesenke in die wärmeleitende Isolierschicht integriert ist; und wobei die wärmeleitende Isolierschicht in indirektem Kontakt mit der zweiten Seite des Chips (12) steht.

5. Chipverpackungsstruktur nach Anspruch 1, wobei die Chipverpackungsstruktur ferner eine Lötscheibe (40) umfasst; die Lötscheibe einen ersten Teil und einen zweiten Teil, die miteinander verbunden sind, umfasst; und der erste Teil einen Bereich abdeckt, in dem das Elektrodenkabel (13) die Öffnung (21) freilegt, und der zweite Teil einen Umfangsrand der Öffnung der Isolierschicht (20) abdeckt.

6. Chipverpackungsstruktur nach Anspruch 1, wobei die Wärmesenke ein Metallblech (31) umfasst und das Metallblech in der Verpackungsschicht (10) durch Galvanisieren ausgebildet ist.

7. Chip-Verpackungsstruktur nach Anspruch 6, wobei die Wärmesenke (30) ferner eine Vielzahl von Wärmeableitungsrippen (32) umfasst, die Wärmeableitungsrippen auf einer Seite ausgebildet sind, die zu dem Metallblech (31) gehört und die von der Verpackungsschicht (10) abgewandt ist, und zwischen den Wärmeableitungsrippen Lücken vorhanden sind.

8. Elektronisches Gerät (1000), umfassend eine Leiterplatte (300) und die Chip-Verpackungsstruktur nach einem der Ansprüche 1 bis 7, wobei ein Teil des Elektrodenkabels (13), der die Öffnung (21) in der Chip-Verpackungsstruktur freilegt, elektrisch mit der Leiterplatte verbunden ist.

## Revendications

1. Structure de boîtier de puce (100), comprenant une couche isolante (20), une couche de boîtier (10), et un dissipateur thermique (30) stratifiés séquentiellement, dans laquelle la couche de boîtier comprend un substrat de boîtier (11), une puce (12), et un câble d'électrode (13), la puce est intégrée au substrat de boîtier, la puce comprend un premier côté et un second côté opposés l'un à l'autre, la puce comprend une première électrode (121) disposée sur le premier côté, et le câble d'électrode est formé sur une surface du substrat de boîtier et connecté électriquement à la première électrode ; la couche isolante recouvre le câble d'électrode, une ouverture (21) est disposée sur la couche isolante, et l'ouverture est disposée en correspondance avec le câble d'électrode pour exposer une partie du câble d'électrode ; et le dissipateur thermique est intégré à la couche de boîtier, dans laquelle le second côté de la puce est recouverte d'une couche métallique (50), **caractérisée en ce que** la couche métallique est connectée électriquement au câble d'électrode et la puce comprend une seconde électrode disposée sur le second côté, et la couche métallique est la seconde électrode.

2. Structure de boîtier de puce selon la revendication 1, dans laquelle le substrat de boîtier (11) comprend une cavité de logement (14), la puce (12) est logée dans la cavité de logement, il existe un espace entre la puce et la cavité de logement, et l'espace est rempli d'un matériau isolant thermiquement conducteur (15).

3. Structure de boîtier de puce selon la revendication 2, dans laquelle le dissipateur thermique : (30) est laminé sur le substrat de boîtier (11) et est intégré au substrat de boîtier, et le dissipateur thermique est en contact avec le deuxième côté de la puce (12).

4. Structure de boîtier de puce selon l'une quelconque des revendications 1 à 2, dans laquelle la structure de boîtier de puce comprend également une couche isolante thermoconductrice (60), et la couche isolante thermoconductrice recouvre la couche de boîtier (10), le dissipateur thermique (30) est situé sur un côté qui est celui de la couche isolante thermoconductrice et qui est éloigné de la couche de boîtier, et le dissipateur thermique est intégré à la couche isolante thermoconductrice ; et la couche isolante thermoconductrice est en contact indirect avec le second côté de la puce (12).

5. Structure de boîtier de puce selon la revendication 1, dans lequel la structure de boîtier de puce comprend également une rondelle de soudure (40) ; la rondelle de soudure comprend une première partie et une seconde partie qui sont connectées ; et la première partie recouvre une zone dans laquelle le câble d'électrode (13) expose l'ouverture (21), et la seconde partie recouvre un bord périphérique de l'ouverture de la couche isolante (20).

6. Structure de boîtier de puce selon la revendication 1, dans laquelle le dissipateur thermique comprend une feuille métallique (31), et la feuille métallique est formée dans la couche de boîtier (10) par galvanoplastie.

7. Structure de boîtier de puce selon la revendication 6, dans laquelle le dissipateur thermique (30) comprend également une pluralité d'ailettes de dissipation thermique (32), les ailettes de dissipation thermique sont formées sur un côté qui est celui de la feuille métallique (31) et qui est éloigné de la couche de boîtier (10), et il existe des espaces entre les ailettes de dissipation thermique.

8. Dispositif électronique (1000), comprenant une carte de circuit imprimé (300) et la structure de boîtier de puce selon l'une quelconque des revendications 1 à 7, dans lequel une partie du câble d'électrode (13) qui expose l'ouverture (21) dans la structure de boîtier de puce est connectée électriquement à la carte de circuit imprimé.
